# EUROPEAN PATENT APPLICATION

(11) **EP 2 631 662 A1**
(43) Date of publication of application: **28.08.2013**
(21) Application number: 10858619.9
(22) Date of filing: 19.10.2010
(51) Int. Cl.: G01R 31/28, H03K 5/19

(54) **INTEGRATED CIRCUIT AND TESTING METHOD**

(71) Applicant: Fujitsu Limited, Kawasaki-shi, Kanagawa 211-8588 (JP)
(72) Inventor: OKAMOTO, Hiroshi, Ishikawa 929-1196 (JP)
(74) Representative: HOFFMANN EITLE
(86) International application number: PCT/JP2010/068399
(87) International publication number: WO 2012/053063

(57) **Abstract**

An oscillation detecting circuit (15) of a JTAG-LSI (10) is provided between an input pin (11), through which the oscillating signal of an oscillator (20) is input, and a boundary register cell (12). The oscillation detecting circuit (15) makes a control such that a signal output from the oscillator (20) is received through the input pin (11), the frequency of the signal is counted, and a value of "1" is stored in the boundary register cell (12) when the frequency is equal to or more than the counter upper limit. Herein, in a case where the value stored in the boundary register cell (12) is "1", it is possible to determine that the wiring paths between the oscillator (20) and the JTAG-LSI (10) is appropriate.

## Description

### TECHNICAL FIELD

The present invention relates to an integrated circuit and a testing method.

### BACKGROUND ART

In recent years, in printed circuit boards, LSIs (Large Scale Integrated Circuits) are increasing in scale and in packaging density, and thus the printed circuit board is substantially difficult to be tested. In order to cope with such an LSI, a JTAG (Join Test Action Group) which is an industry-standard test circuit is mounted on the LSI, so that the testing is easily achieved using the JTAG.

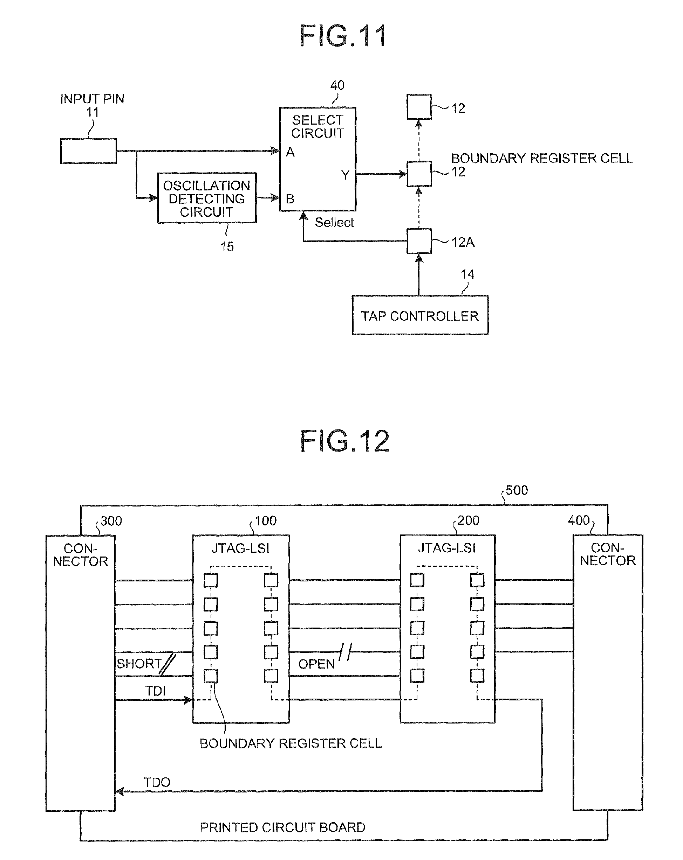

Herein, a configuration example of a printed circuit board including a JTAG-LSI which is an integrated circuit mounting the JTAG will be described using FIG. 12. FIG. 12 is a diagram illustrating a configuration of the printed circuit board including a conventional JTAG-LSI. As illustrated in FIG. 12, JTAG-LSIs 100 and 200 which are the LSIs mounting the JTAG and connectors 300 and 400 are mounted on the same printed circuit board 500.

The JTAG-LSI 100 includes a plurality of boundary register cells, and is connected to the connector 300 and the JTAG-LSI 200. In addition, the JTAG-LSI 200 includes a plurality of boundary register cells, and is connected to the connectors 300 and 400 and the JTAG-LSI 100. In addition, the connector 300 is connected to the JTAG-LSI 100, and also connected to a tester (not illustrated).

On the basis of the configuration, a case of testing wiring paths from the connector 300 to the JTAG-LSI 100 will be described. When testing the printed circuit board 500, the JTAG-LSI 100 receives a test signal output from the tester which is connected to the connector 300, and holds the signal value of the test signal in the boundary register. Then, the JTAG-LSI 100 outputs the signal value as a TDO (Test Data Out) through the JTAG-LSI 200 and the connector 300 to the tester. Thereafter, the signal value is determined whether it is appropriate, and the wiring paths are tested whether there is a problem.

In other words, when the signal value output as the TDO is equal to the signal value of the test signal output from the tester, it is determined that there is no problem in the wiring paths. When the signal value output as the TDO is not equal to the signal value of the test signal output from the tester, it is determined that the signal value is changed due to a failure in the wiring paths such as a short circuit or an open circuit.

### CITATION LIST

### PATENT LITERATURE

Patent Literature 1: Japanese Laid-open Patent Publication No. 2002-98740
Patent Literature 2: Japanese Laid-open Patent Publication No. 2002-74994

### DISCLOSURE OF INVENTION

### PROBLEM TO BE SOLVED BY THE INVENTION

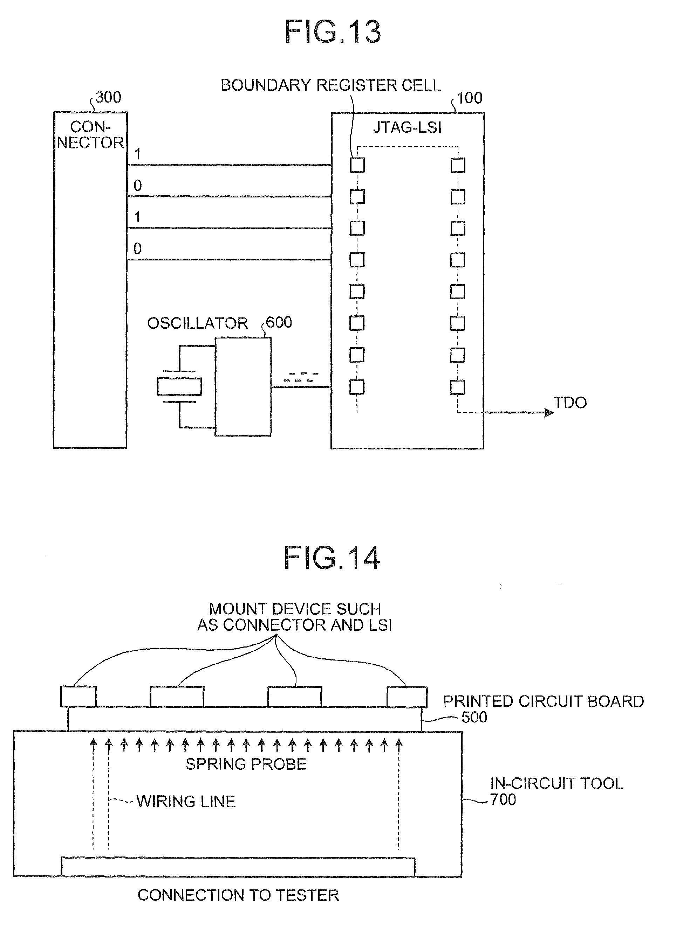

However, in the testing method for the wiring paths described above, when the JTAG-LSI receives the signal output from the oscillator, there is a problem in that the wiring paths from the oscillator to the integrated circuit is not able to be tested appropriately. In other words, as illustrated in FIG. 13, since an output signal output from an oscillator 600 varies from "0" to "1" or from "1" to "0", even though the output signal is stored in the boundary register cell and then is output as the TDO, it is difficult to determine whether or not the signal value of the output TDO is appropriate. For this reason, it is difficult to appropriately test the wiring paths from the oscillator 600 to the integrated circuit.

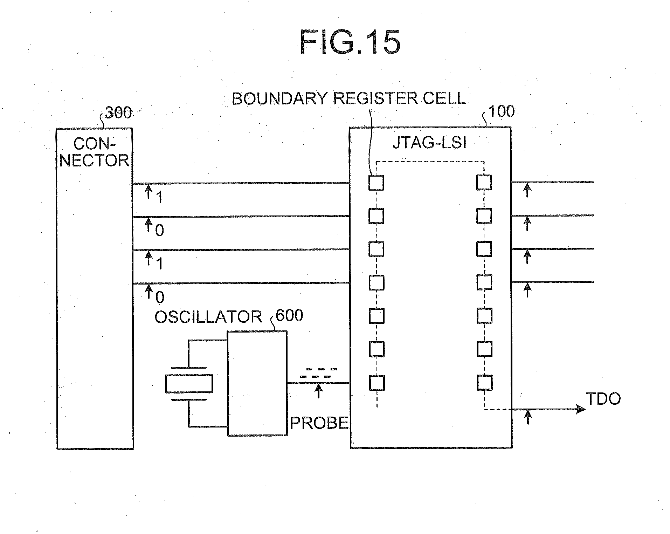

Further, it may be also considered that the output of the oscillator is tested through a testing using an in-circuit test and through a lead line. For example, as illustrated in FIG. 14, the wiring paths are tested using an in-circuit tool 700 of which spring probes come into contact with the respective signal nodes of the printed circuit board 500 to test the signal. In other words, as illustrated in FIG. 15, signals flow directly to the signal nodes through the contacted spring probes, or driven signals are directly received so as to test the wiring paths. However, in the testing using the in-circuit test, an expensive tool is used; the wiring line from the probe to the JTAG-LSI (the test target) 100 is not able to be tested; and it is difficult to appropriately test the wiring paths from the oscillator 600 to the JTAG-LSI 100.

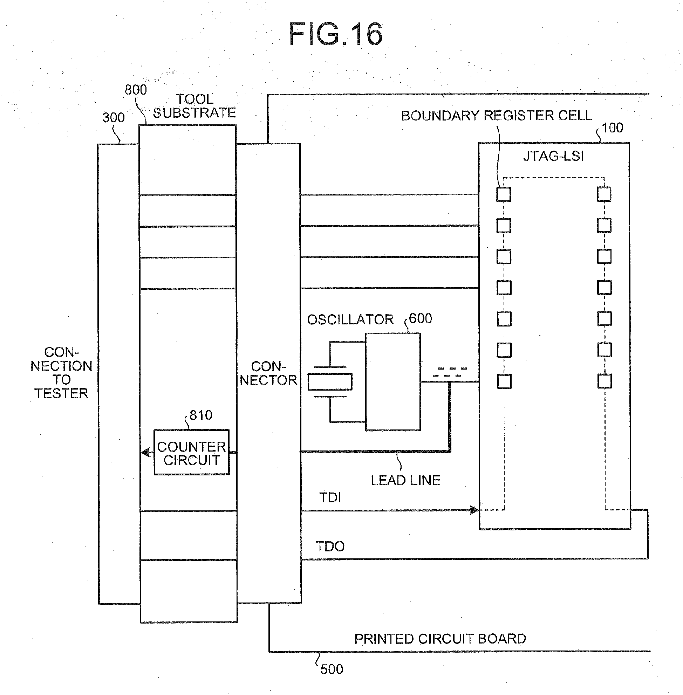

In addition, for example, as illustrated in FIG. 16, in the testing using the lead line, the lead line is provided in the wiring paths between the oscillator 600 and the JTAG-LSI 100, an output signal of the oscillator 600 is output to a counter circuit 810 which is provided in a tool substrate 800. Then, the counter circuit 810 measures the frequency of the output signal output from the oscillator 600, and outputs the measured frequency to a tester for the testing of the wiring paths. However, in the testing using the lead line, the wiring line from the lead line to the input pin of the JTAG-LSI (the test target) 100 is not able to be tested. In addition, the tool having the lead line is necessarily provided on each printed circuit board, and since the output signal is led out through the lead line, there may be scattering in the oscillation waveform of the oscillator 600. Therefore, it is difficult to appropriately test the wiring paths from the oscillator 600 to the JTAG-LSI 100.

According to an aspect, an object is to test an oscillating of the oscillator and to appropriately test the wiring paths from the oscillator to the integrated circuit without using a special tool.

### MEANS FOR SOLVING PROBLEM

In a first suggestion, there is provided a control unit which makes a control such that the value of a signal input from an input pin is stored in a register cell, and the value stored in the register cell is output to the outside. In addition, there is provided an oscillation detecting unit which receives a signal output from an oscillator through the input pin, and stores a predetermined value in the register cell when it is detected that the signal is oscillating.

### EFFECT OF THE INVENTION

Wiring paths from an oscillator to an integrated circuit are able to be appropriately tested.

### BRIEF DESCRIPTION OF DRAWINGS

FIG. 1 is a block diagram illustrating a configuration of a JTAG-LSI according to a first embodiment.
FIG. 2 is a diagram illustrating a TAP controller.
FIG. 3 is a diagram illustrating TAP states.
FIG. 4 is a block diagram illustrating a detailed configuration of an oscillation detecting circuit.
FIG. 5 is a diagram illustrating a time chart of an oscillation detecting process.
FIG. 6 is a diagram illustrating a short-failure detecting process.
FIG. 7 is a block diagram illustrating a configuration of a JTAG-LSI according to a second embodiment.
FIG. 8 is a block diagram illustrating a detailed configuration of the JTAG-LSI to which a frequency measuring circuit is added.
FIG. 9 is a block diagram illustrating a detailed configuration of the frequency measuring circuit.
FIG. 10 is a diagram illustrating a time chart of a frequency measuring process.
FIG. 11 is a diagram illustrating a switching process in which the output of an oscillator mounted on another circuit board is switched with the output of the oscillation detecting circuit.
FIG. 12 is a diagram illustrating a configuration of a printed circuit board including a conventional JTAG-LSI.
FIG. 13 is a diagram illustrating a case where the conventional JTAG-LSI tests the output of the oscillator.
FIG. 14 is a diagram illustrating a testing which is performed by an in-circuit tester.
FIG. 15 is a diagram illustrating a testing which is performed by an in-circuit tester.
FIG. 16 is a diagram illustrating a testing which is performed by a lead line.

### BEST MODE(S) FOR CARRYING OUT THE INVENTION

Hereinafter, embodiments of an integrated circuit and a testing method according to the invention will be described in detail with reference to the accompanying drawings.

### First Embodiment

In the following, a configuration of a JTAG-LSI according to a first embodiment and a processing flow will be sequentially described, and the effects of the first embodiment will be described at the end.

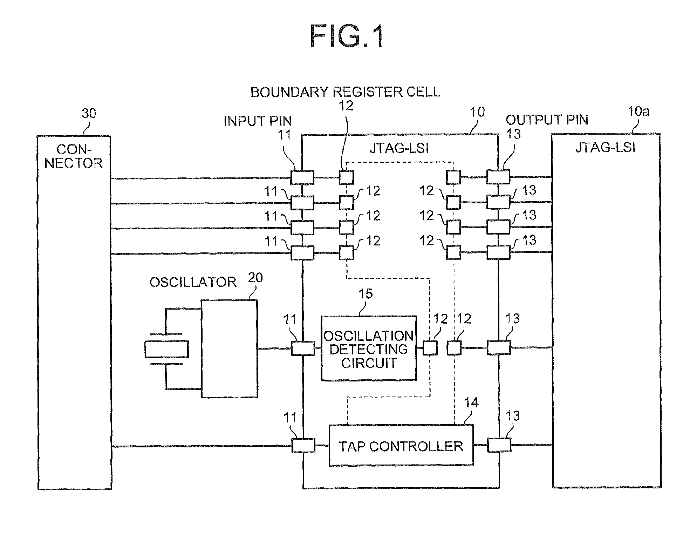

First, the configuration of a JTAG-LSI 10 will be described using FIG. 1. FIG. 1 is a block diagram illustrating the configuration of the JTAG-LSI according to the first embodiment. As illustrated in FIG. 1, the JTAG-LSI 10 includes a plurality of input pins 11, a plurality of boundary register cells 12, a plurality of output pins 13, a TAP controller 14, and an oscillation detecting circuit 15. In addition, the JTAG-LSI 10 connects an oscillator 20, a connector 30, and a JTAG-LSI 10a through wiring lines. Hereinafter, the processes of these components will be described.

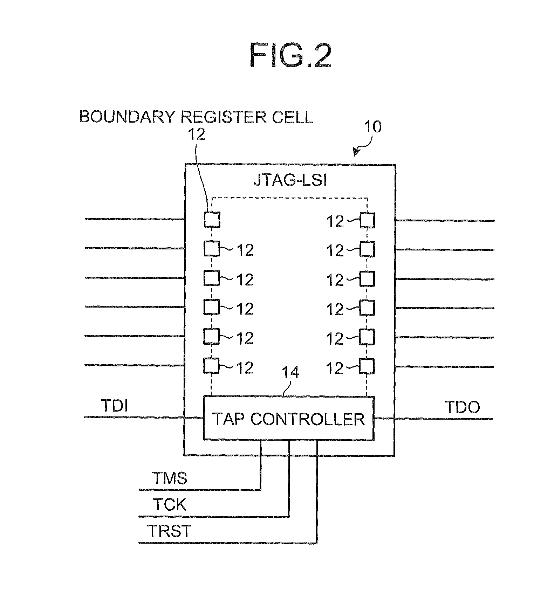

The oscillator 20 outputs an oscillating signal to the JTAG-LSI 10 through the input pin 11. The value of the oscillating signal which is output from the oscillator 20 is changed constantly from "0" to "1" or from "1" to "0". The connector 30 is connected to a tester (not illustrated), and outputs the signal from the tester to the JTAG-LSI 10. In addition, the tester outputs a control signal to the JTAG-LSI 10, which will be described below using FIG. 2.

The input pin 11 is a terminal which is used to receive the signal from the oscillator 20 or the connector 30 to the JTAG-LSI 10. In addition, the output pin 13 is a terminal which reads a test signal which is output to the JTAG-LSI 10a from the boundary register cell 12, and outputs the signal.

The boundary register cell 12 stores a value of the signal which is received from the input pin 11. In addition, the boundary register cell 12 stores an output signal, as a test signal which is output to the JTAG-LSI 10a, which is shifted in from the TDI.

The TAP controller 14 makes a control such that the value of the signal input from the input pin 11 is stored in the boundary register cell 12, and the value stored in the boundary register cell 12 is output to the outside. Herein, the TAP controller will be described using FIG. 2. FIG. 2 is a diagram illustrating the TAP controller. As illustrated in FIG. 2, the TAP controller 14 receives, as control signals, a TDI (Test Data In), a TMS (Test Mode Select), a TCK (Test Clock), and a TRST (Test Reset) from the tester which is connected to the connector 30.

The TDI is a signal which is used for the reception of data to be stored in the boundary register cell 12 or instruction data to be set in an instruction register. The TMS is a control signal which is used to control the state of the TAP controller 14. The TCK is a control signal which is used to control process timing of the TAP controller 14 or to capture data from the TDI to the boundary register cell 12 or the instruction register. The TRST is a control signal which initializes the state of the AP controller 14 to be shifted to a "Test-Logic-Reset" state. In addition, as a test result, the TAP controller 14 outputs the data stored in the boundary register cell 12 as a TDO (Test Data Out).

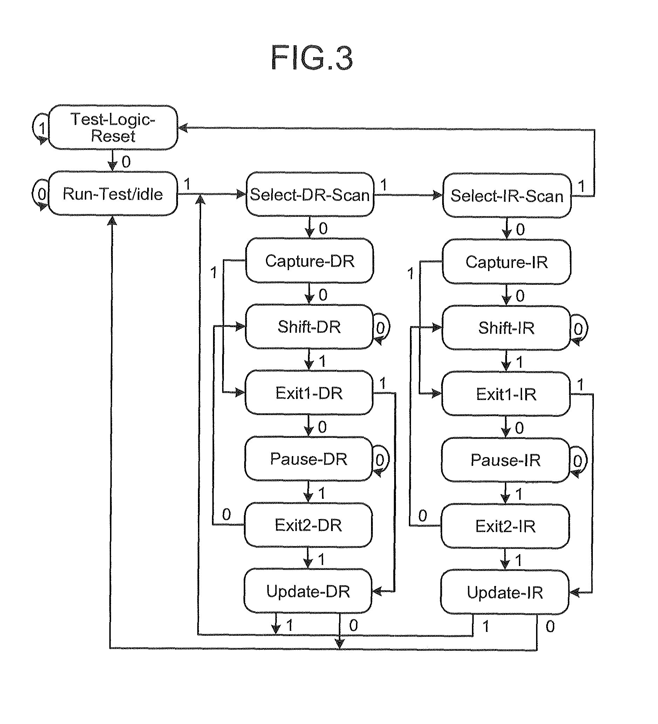

Herein, the state (hereinafter, referred to as a TAP state) of the TAP controller 14 which is shifted depending on the TMS will be described using FIG. 3. FIG. 3 is a diagram illustrating the TAP states. As illustrated in FIG. 3, the TAP controller 14 is controlled in 16 types of TAP states. The TAP states include "Test-Logic-Reset", "Run-Test/idle", "Select-DR-Scan", "Capture-DR", "Shift-DR", "Exit1-DR", "Pause-DR", "Exit2-DR", and "Update-DR", in which the flows of the states written in XXX-DR are for controlling data caused by the instruction. In addition, the TAP states include "Select-IR-Scan", "Capture-IR", "Shift-IR", "Exit1-IR", "Pause-IR", "Exit2-IR", and "Update-IR", in which the flows of the states written in XXX-IR are for setting the instruction.

The TAP state can be shifted in states depending on whether the TMS value at a rising edge of the TCK is "0" or "1" while the TRST is "1". For example, in the example illustrated in FIG. 3, "1" or "0" which is denoted at the side of an arrow drawn in each TAP state indicates the TMS value, and the state is shifted to another one pointed by the arrow depending on the TMS value.

The TAP controller 14 shifts the TAP state depending on whether the TMS level is "0" or "1" at the rising edge of the TCK when the TRST is "1". For example, as illustrated in FIG. 3, in a case where the TMS level is "0" at the rising edge of the TCK in the initial state "Test-Logic-Reset", the TAP controller 14 shifts the state to "Run-Test/idle" which indicates the test start or the standby state.

In addition, the state is not changed in a case where the TMS level is "1" at the rising edge of the TCK in the "Test-Logic-Reset" state. Subsequently, in a case where the TMS level is "1" at the rising edge of the TCK in the "Run-Test/idle" state, the TAP controller 14 shifts the state to the "Select-DR-Scan" state which indicates a state of selecting data control. In addition, the TAP controller does not change the state in a case where the TMS level is "0" at the rising edge of the TCK in the "Run-Test/idle" state.

Subsequently, in a case where the TMS level is "1" at the rising edge of the TCK in the "Select-DR-Scan" state, the TAP controller 14 shifts the state to the "Select-IR-Scan" state which indicates a state of selecting an instruction to be executed from the instruction register. In addition, subsequently, in a case where the TMS level is "0" at the rising edge of the TCK in the "Select-DR-Scan" state, the TAP controller 14 shifts the state to the "Capture-DR" state which indicates a state of capturing data.

The oscillation detecting circuit 15 is provided between the input pin 11, through which the oscillating signal of the oscillator 20 is input, and the boundary register cell 12. The oscillation detecting circuit 15 receives a signal output from the oscillator 20 through the input pin 11, and outputs a predetermined value to the boundary register cell 12 when it is detected that the signal is oscillating. Specifically, the oscillation detecting circuit 15 receives the signal output from the oscillator 20 through the input pin 11, counts the frequency of the signal, and outputs "1" to the boundary register cell 12 in a case where the frequency is equal to or more than a counter upper limit.

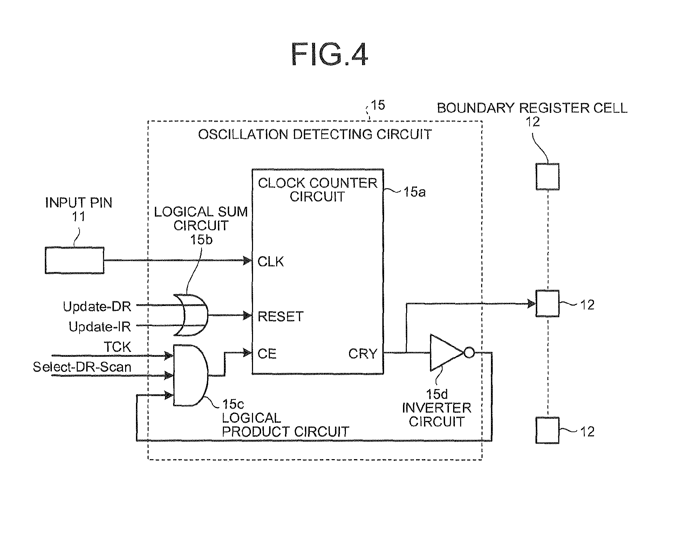

Herein, a detailed circuit configuration of the oscillation detecting circuit 15 will be described using FIG. 4. FIG. 4 is a block diagram illustrating a detailed configuration of the oscillation detecting circuit 15. As illustrated in FIG. 4, the oscillation detecting circuit 15 includes a clock counter circuit 15a, a logical sum circuit 15b, a logical product circuit 15c, and an inverter circuit 15d. In addition, the input pin 11 illustrated in FIG. 4 receives the oscillating signal output from the oscillator 20, and transmits the received signal to the clock counter circuit 15a.

The clock counter circuit 15a counts the frequency of the oscillating signal received from the oscillator 20, and sets the boundary register cell 12 to be "1" in a case where while the TCK is "1", the counted frequency reaches the counter upper limit which is predetermined in advance. Specifically, as illustrated in FIG. 4, the clock counter circuit 15a includes a "CLK (clock)" terminal of the clock counter which counts the oscillating signal pulses of the oscillator 20 input through the input pin 11 while the TCK is "1".

In addition, the clock counter circuit 15a sets a "CRY (carry)" terminal to be "1" in a case where the counted value reaches the counter upper limit while the TCK is "1". Further, the counter upper limit, for example, is set to be lower than 8 in a case where a tester having a maximum TCK pulse width of 500 ns is used and the 16 MHz oscillator 20 is tested.

In addition, the clock counter circuit 15a includes a "RESET" terminal which serves as a terminal to reset the counter value in a case of an Update-DR state or an Update-IR state. The clock counter circuit 15a resets the clock counter value in a case where the reset terminal receives a signal value of "1" from the logical sum circuit 15b.

In addition, the clock counter circuit 15a stops the counting when a signal value of "0" is received by a "CE" terminal (which serves as a clock enable terminal) from the logical product circuit 15c. In addition, in a case where the counted value reaches the counter upper limit while the TCK is "1", the clock counter circuit 15a stores "1" in the "CRY" terminal (which serves as a carry terminal), and the stored value is captured into the boundary register cell 12 at the rising edge of the TCK in the Capture-DR state.

Further, in a case where the clock counter 15a counts the frequency of the oscillating signal which is input from the oscillator 20, a count reference time of the clock counter 15a is a time when the TCK is "1". Since the JTAG tester is configured to fix the time when the TCK is "1" in many cases, the reference time is generated using the fixed time and thus a dedicated clock for generating the reference time is not provided.

The logical sum circuit 15b outputs "1" to the reset terminal of the clock counter circuit 15a in a case of the Update-DR state or the Update-IR state. The logical product circuit 15c outputs "1" to the clock enable terminal of the clock counter circuit 15a in a case where the TCK is "1" and the inverter circuit 15d outputs "1" in the Select-DR-Scan state. Then, when the clock enable terminal becomes "1", the clock counter 15a begins to count the frequency of the oscillating signal input from the oscillator 20.

The inverter circuit 15d outputs a signal value of "1" to the logical product circuit 15c in a case where the carry terminal outputs a value of "0", and outputs a signal value of "0" to the logical product circuit 15c in a case where the carry terminal outputs a value of "1". Then, when the value of the carry terminal becomes "1", since the logical sum circuit 15b outputs a value of "0", and the CE terminal becomes "0", the clock counter 15a stops the counting. In other words, in a case where the clock counter 15a counts the frequency up to the counter upper limit, the value of the carry terminal becomes "1" and thus the counting is stopped.

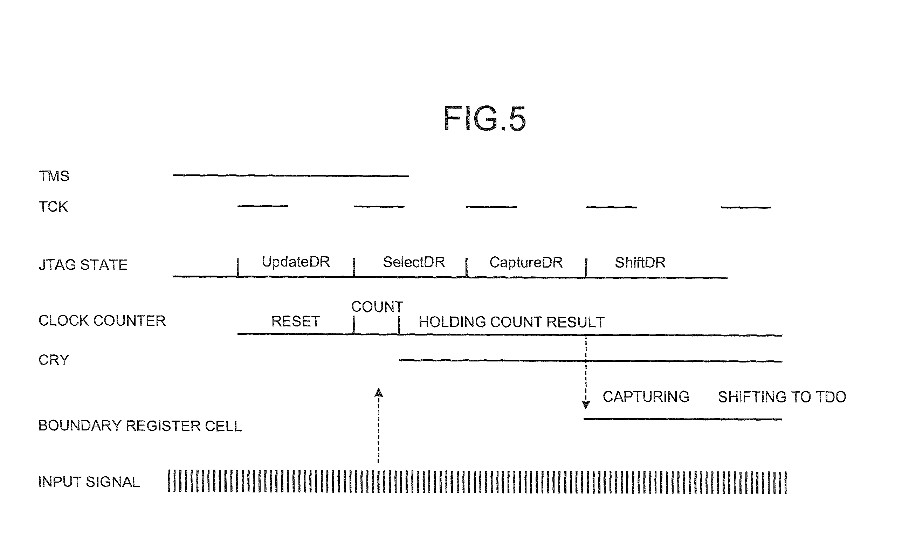

Herein, an oscillation detecting process will be described using FIG. 5. FIG. 5 is a diagram illustrating a time chart of the oscillation detecting process. Further, in the example of FIG. 5, the horizontal axis represents a time axis; and the TMS, the TCK, the CRY, and the boundary register cell are illustrated with a value of "1" when a horizontal line is drawn and "0" when the horizontal line is not drawn. In addition, in the example of FIG. 5, the state of the TAP controller is indicated in a JTAG state, and the state of the clock counter is indicated in the clock counter.

As illustrated in FIG. 5, the oscillation detecting circuit 15 outputs "1" to the reset terminal of the clock counter circuit 15a to set the clock counter to "0" in a case where the JTAG state is in the Update-DR state. Then, since the TMS becomes "1" at the next rising edge of the TCK, the JTAG state is shifted from the Update-DR state to a SelectDR state, and the clock counter circuit 15a counts the signal pulses input from the oscillator 20 while the TCK is "1" and holds the count result. Then, the oscillation detecting circuit 15 sets the carry value to "1" in a case where the count result reaches the counter upper limit.

Thereafter, since the TMS becomes "0" at the next rising edge of the TCK, the JTAG state is shifted from the SelectDR state to the captureDR state, the carry value "1" is captured into the boundary register cell 12 at the next rising edge of the TCK. At this time, since the TMS is "0", the JTAG state is shifted from the captureDR state to the ShifiDR state. In the ShifiDR state, the value of the boundary register cell 12 is shifted at every rising edge of the TCK by 1 bit in a direction of the TDO, and then sequentially pushed out from the TDO to the JTAG-LSI 10a.

Herein, in a case where the value stored in the boundary register cell 12 is "1", since the signal of the oscillator 20 is being detected whether it oscillates appropriately, it is possible to determine that the oscillator 20 is oscillated and the wiring paths between the oscillator 20 and the JTAG-LSI 10 is appropriate.

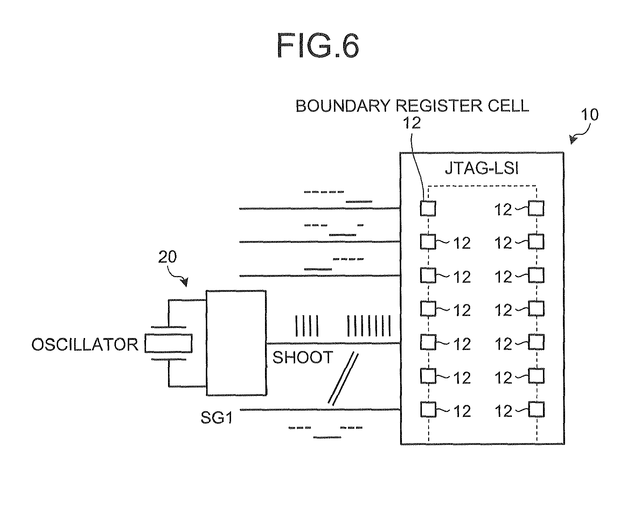

In addition, since the JTAG-LSI 10 according to the first embodiment can be tested at every change occurring in the output from the connector 30, a short failure is detected through the testing in which "0" or "1" is alternatively output through adjacent printed wiring lines. For example, as illustrated in FIG. 6, in a case where the wiring line connected to the oscillator 20 is short-circuited to a SIG (Signal) line, and the "0" output of the SIG line is strong, the output of the oscillator 20 is disconnected at the "0" output portion and thus a failure is detected. FIG. 6 is a diagram illustrating the short-failure detecting process.

### Advantages of First embodiment

As described above, the JTAG-LSI 10 includes the boundary register cell 12 which stores a signal value input from the input pin. Then, the JTAG-LSI 10 makes a control such that the signal value input from the input pin 11 is stored in the boundary register cell 12, and the value stored in the boundary register cell 12 is output to the outside. The JTAG-LSI 10 receives a signal output from the oscillator 20 through the input pin 11, and stores a predetermined value in the boundary register cell 12 when it is detected that the signal is oscillating. Therefore, it is possible to appropriately test whether the wiring paths from the oscillator 20 to the JTAG-LSI 10 are appropriate. In addition, there is no need for an expensive in-circuit tool; since no lead lines are used, there is no scattering in the oscillation waveform of the oscillator; and it is possible to easily and appropriately test the oscillation result of the oscillator 20 and the wiring paths from the oscillator 20 to the JTAG-LSI 100.

In addition, according to the first embodiment, the JTAG-LSI 10 makes a control such that the signal output from the oscillator 20 is received through the input pin 11, the frequency of the signal is counted, and a predetermined value is stored in the boundary register cell 12 in a case where the frequency is equal to or more than a predetermined number. Therefore, since the JTAG-LSI 10 outputs the value stored in the boundary register cell 12, and monitors the output value, it is possible to appropriately test the oscillation result of the oscillator 20 and the wiring paths from the oscillator 20 to the JTAG-LSI 10.

### Second Embodiment

By the way, in the first embodiment described above, the description has been made in connection to that in a case where the frequency of the signal output from the oscillator is equal to or more than a predetermined threshold value, a predetermined value is stored in the boundary register cell and is output through the TDO. However, the examples are not limited the above configuration, and it may be configured such that the frequency of the signal output from the oscillator is measured, and the frequency is stored in a dedicated cell and then output through the TDO.

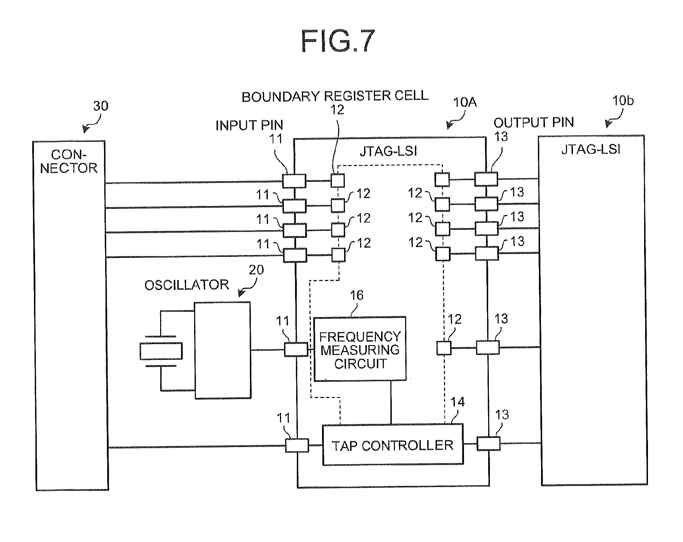

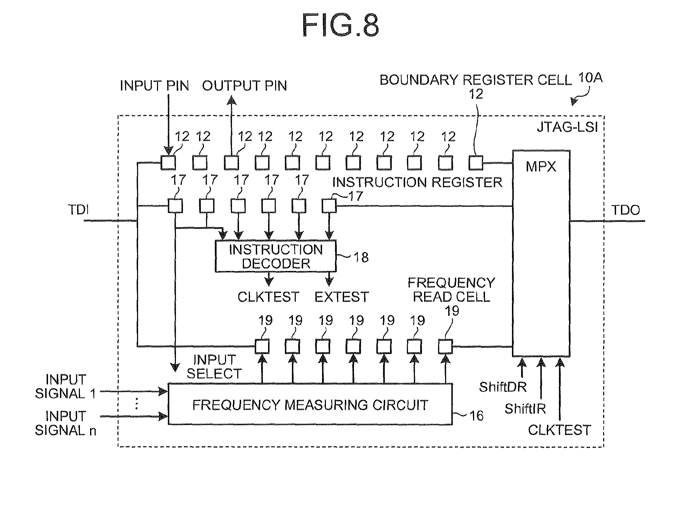

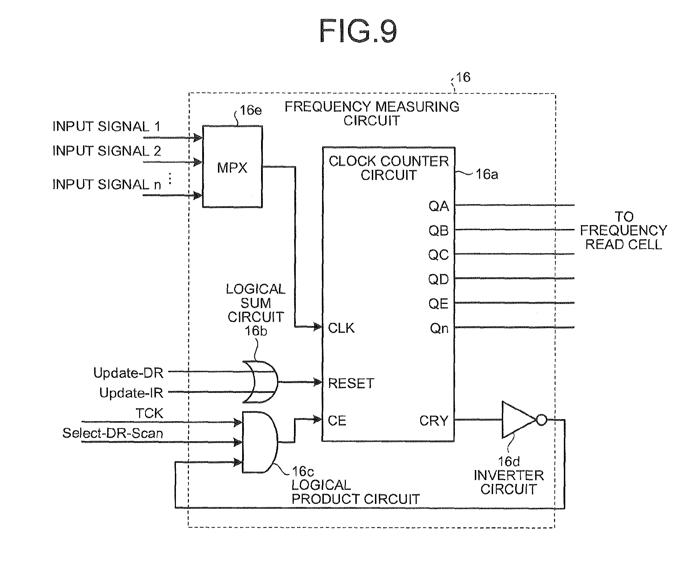

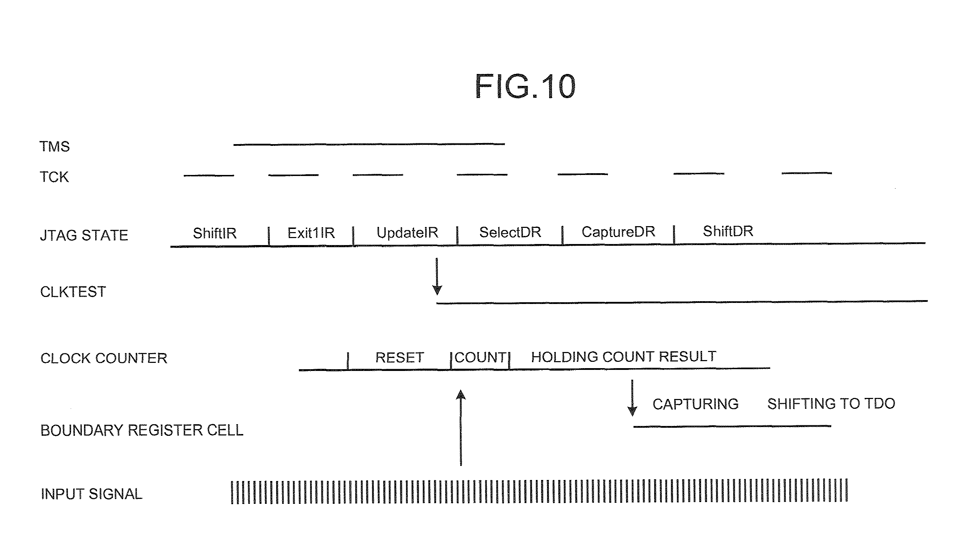

In a second embodiment to be described below, a JTAG-LSI 10A according to the second embodiment, as a case in which the frequency of the signal output from the oscillator is measured, and the frequency is stored in the dedicated cell and then output through the TDO, will be described using FIGS. 7 to 10. FIG. 7 is a block diagram illustrating a configuration of the JTAG-LSI according to the second embodiment. FIG. 8 is a block diagram illustrating a detailed configuration of the JTAG-LSI. FIG. 9 is a block diagram illustrating a detailed configuration of a frequency measuring circuit. FIG. 10 is a diagram illustrating a time chart of a frequency measuring process.

As illustrated in FIG. 7, the JTAG-LSI 10A is different from the JTAG-LSI 10 illustrated in FIG. 1 in that a frequency measuring circuit 16 is newly provided instead of the oscillation detecting circuit 15. In the JTAG-LSI 10A, the frequency measuring circuit 16 detects the signal output from the oscillator 20, counts the frequency of the output signal, and stores the counted frequency in a frequency read cell.

Herein, a detailed circuit configuration of the JTAG-LSI 10A according to the second embodiment will be described using FIG. 8. As illustrated in FIG. 8, the JTAG-LSI 10A includes the frequency measuring circuit 16, a plurality of instruction registers 17, an instruction decoder 18, a plurality of frequency read cells 19, and an MPX (Multiplexer) 19a.

The instruction register 17 stores an instruction which is received as the TDI from the tester through the connector 30, and determines the inner operation of the JTAG-LSI 10A. In addition, the instruction decoder 18 reads an instruction code stored in the instruction register 17 to decode the instruction code. Herein, the JTAG-LSI 10A according to the second embodiment is newly provided with an instruction code of "EXTEST" for a usual test in which the value of the signal input through the input pin is stored in the boundary register 12, a dedicated instruction of "CLKTEST" which is a counter read instruction, and a frequency read cell which is a data register corresponding to the instruction. Further, the JTAG-LSI 10A sends the code of the counter read instruction to the instruction register through the Shift-IR terminal, and the code is captured into the instruction register through the Update-IR terminal.

The frequency read cell 19 stores a frequency which is the frequency of the signal output from the oscillator 20, and counted by the frequency measuring circuit 16. Further, the frequency read cell 19 stores the frequency as a data cell corresponding to the "CLKTEST" instruction. The MPX 19a selects any one of the value stored in the boundary register cell 12, the value output from the instruction register 17, and the value stored in the frequency read cell 19, and outputs the selected value through the TDO terminal.

The frequency measuring circuit 16 makes a control such that the signal output from the oscillator 20 is received through the input pin 11, the frequency of the signal is counted, and the counted frequency is stored in the frequency read cell 19.

Herein, a detailed circuit configuration of the frequency measuring circuit 16 will be described using FIG. 9. As illustrated in FIG. 9, the frequency measuring circuit 16 includes a clock counter circuit 16a, a logical sum circuit 16b, a logical product circuit 16c, an inverter circuit 16d, and an MPX 16e. Further, the logical sum circuit 16b, the logical product circuit 16c, and the inverter circuit 16d have the same configuration as those of the logical sum circuit 15b, the logical product circuit 15c, and the inverter circuit 15d of FIG. 4, and the descriptions thereof will not be provided.

The clock counter circuit 16a is different from the clock counter circuit 15a of FIG. 4 in that output terminals QA, QB, QC, QD, QE, and Qn are provided to output the counted frequency to the frequency read cell 19. The clock counter circuit 16a counts the frequency of the output signal, and outputs the counted frequency from the output terminals QA, QB, QC, QD, QE, and Qn to the frequency read cell 19.

In addition, the MPX 16e receives signals input from the oscillator 20, and selects any one input signal of which the frequency is counted. In the example of FIG. 9, the MPX 16e receives the signals input from a plurality of oscillators 20, receives a part of the instruction bits as input select signals, and selects any one input signal of which the frequency is counted.

Herein, the frequency measuring process will be described using FIG. 10. FIG. 10 is a diagram illustrating a time chart of the frequency measuring process. Further, in the example of FIG. 10, the horizontal axis represents a time axis; and the TMS, the TCK, the CRY, and the boundary register cell 12 are illustrated with a value of "1" when a horizontal line is drawn and "0" when the horizontal line is not drawn. In addition, in the example of FIG. 10, the state of the TAP controller is indicated in a JTAG state, and the state of the clock counter is indicated in the clock counter.

As illustrated in FIG. 10, the frequency measuring circuit 16 sends the instruction code of the CLKTEST which is the counter read instruction to the instruction register 17 in a case where the JTAG state is the shiftIR state, and proceeds from the ExitIR state to the Update-IR state.

The frequency measuring circuit 16 outputs "1" to the reset terminal of the clock counter circuit 16a to set the clock counter to "0" in a case where the JTAG state is the Update-IR state. Since the TMS becomes "1" at the next rising edge of the TCK, the JTAG state is shifted from the Update-IR state to the SelectDR state. Further, the clock counter counts the signal pulses input from the oscillator 20 while the TCK is "1", and holds the count result. In a case where the count result reaches the counter upper limit, the frequency measuring circuit 16 sets the carry value to "1", stops the counting, and illustrates the counter upper limit.

Thereafter, since the TMS becomes "0" at the next rising edge of the TCK, the JTAG state is shifted from the SelectDR state to the captureDR state, the count result is captured into the frequency read cell 19 at the next rising edge of the TCK. At this time, since the TMS is "0", the JTAG state is shifted from the captureDR state to the ShifiDR state. Next, in the ShifiDR state, the value of the frequency read cell 19 is shifted by 1 bit at every rising edge of the TCK in the direction of the TDO, and then sequentially pushed out from the TDO to the JTAG-LSI 10b.

According to the second embodiment, the JTAG-LSI 10A includes the frequency read cell 19 which stores the frequency of the signal output from the oscillator. Further, the JTAG-LSI 10A makes a control such that a signal output from the oscillator 20 is received through the input pin 11, the frequency of the signal is counted, and the counted frequency is stored in the frequency read cell 19. Therefore, it is possible to appropriately test whether the wiring paths from the oscillator 20 to the JTAG-LSI 10 are appropriate. Further, it is possible to appropriately check the frequency of the oscillator 20.

### Third Embodiment

The invention has been described in connection with the examples, but various different embodiments may be implemented besides the above-mentioned examples. Hereinbelow, another example belonging to the invention will be described as a third embodiment.

### (1) Select circuit

In the first embodiment described above, the description has been made in connection to that in a case where the frequency of the signal output from the oscillator is equal to or more than the predetermined threshold value, the predetermined value is stored in the boundary register cell and is output through the TDO. However, the configuration may be changed to select whether the predetermined value is stored in the boundary register cell, or the value of the signal output from the oscillator is stored in the boundary register cell when it is detected that the output signal is oscillating.

For example, in a case where the oscillator is mounted on a separate substrate from the JTAG-LSI, and the oscillating signal is received through the input pin 11 from the connector, it is easy to perform the testing while the value of the signal received from the connector is directly stored in the boundary register cell 12.

For this reason, as illustrated in FIG. 11, a select circuit 40 is newly provided which uses a boundary register cell 12A not connected to an external pin so as to select whether the output of an oscillation detecting circuit 20 is stored in the boundary register 12, or the value of the signal input through the input pin is stored in the boundary register 12.

For example, in the example of FIG. 11, in a case where the value of the boundary register cell 12A not connected to the external pin is "0", the output of the oscillation detecting circuit 20 is stored in the boundary register 12. In addition, in a case where the value of the boundary register cell 12A is "1", the value of the signal input through the input pin is stored in the boundary register 12.

As described above, when it is detected that the signal output from the oscillator is oscillating, the JTAG-LSI selects whether the predetermined value is stored in the boundary register cell 12, or the value of the signal output from the oscillator is stored in the boundary register cell 12. Therefore, even in a case where the oscillator is mounted on a separate substrate from the JTAG-LSI, the wiring paths from the oscillator to the JTAG-LSI can be appropriately tested.

### (2) System configurations

In addition, the components of the respective devices are functionally and conceptually illustrated, but these components need not be configured as similar as those physically illustrated. In other words, specific embodiments of distribution and integration of the respective devices are not limited to those in the drawings. Further, some or all of the devices may be functionally or physically distributed and integrated in an arbitrary unit according to various load states and usage situations.

In addition, some or all of processes performed automatically among the processes described in the examples may be performed manually. Alternatively, some or all of processes performed manually may be performed automatically according to well-known methods. Otherwise, processing sequences, controlling sequences, specific names, information including various types of data and parameters described in the above specification and drawings can be arbitrarily changed unless particularly stated.

### EXPLANATION OF LETTERS OR NUMERALS

- 10, 10a, 10A: JTAG-LSI
- 11: INPUT PIN
- 12: BOUNDARY REGISTER CELL
- 13: OUTPUT PIN
- 14: TAP CONTROLLER
- 15: OSCILLATION DETECTING CIRCUIT
- 15a: CLOCK COUNTER CIRCUIT
- 15b: LOGICAL SUM CIRCUIT
- 15c: LOGICAL PRODUCT CIRCUIT
- 15d: INVERTER CIRCUIT
- 16: FREQUENCY MEASURING CIRCUIT
- 17: INSTRUCTION REGISTER
- 18: INSTRUCTION DECODER
- 19: FREQUENCY READ CELL
- 19a: MPX
- 20: OSCILLATOR
- 30: CONNECTOR

## Claims

1. An integrated circuit comprising:
a register cell that stores a value of a signal input through an input pin;
a control unit that makes control such that the value of the signal input from the input pin is stored in the register cell, and the value stored in the register cell is output to an outside;
an oscillation detecting unit that receives a signal output from an oscillator through the input pin, and stores a predetermined value in the register cell when it is detected that the signal oscillates.

2. The integrated circuit according to claim 1,
wherein the oscillation detecting unit receives a signal output from the oscillator through the input pin, counts a frequency of the signal, and stores a predetermined value in the register cell when the frequency is equal to or more than a predetermined number.

3. The integrated circuit according to claim 1, further comprising
a frequency storing cell that stores the frequency of the signal output from the oscillator,
wherein the oscillation detecting unit receives the signal output from the oscillator through the input pin, counts the frequency of the signal, and stores the counted frequency in the frequency storing cell.

4. The integrated circuit according to any one of claims 1 to 3, further comprising
a select unit that selects whether the predetermined value is stored in the register cell or the value of the signal output from the oscillator is stored in the register cell when the oscillation detecting unit detects that the signal output from the oscillator oscillates.

5. A testing method comprising:
receiving a signal output from an oscillator through an input pin, and storing a predetermined value in a register cell when it is detected that the signal oscillates; and
making control such that the value stored in the register cell is output to an outside.
